# EUROPEAN PATENT APPLICATION

(11) **EP 2 278 624 A1**
(43) Date of publication of application: **26.01.2011**
(21) Application number: 09166375.7
(22) Date of filing: 24.07.2009
(51) Int. Cl.: H01L 31/0224, H01L 31/18

(54) **Conducting self-cleaning materials and process for producing same**

(71) Applicant: University College Cork-National University of Ireland, Cork, Cork (IE)
(72) Inventor: Pemble, Martyn, County Cork (IE); Nolan, Mark, County Cork (IE); Povey, Ian, Cork City (IE); Hamilton, Jeff, Cork City (IE)
(74) Representative: Lucey, Michael

(57) **Abstract**

The invention provides a self-cleaning material suitable for use as a front contact in a photovoltaic solar cell structure comprising zinc oxide and indium. The advantage of the invention is to provide a multifunctional thin film material, properties of which include (1) transparency, (2) high levels of conductance, (3) durability (4) UV induced photocatalysis and (5) a hydrophilic surface, that can be employed as the front contact on solar cells to minimise the build up of contaminants whilst generating electricity efficiently. By selection of a suitable amount of indium doping in the zinc oxide the invention offers a number of advantages over those associated with existing self-cleaning materials in that it results in the production of self-cleaning properties in a highly conducting film. The invention also provides a process for making self-cleaning materials.

## Description

### Field of the Invention

The invention relates to conducting, self-cleaning materials and process for producing same. In particular the invention relates to self cleaning thin-film materials for use as a transparent front contact in photovoltaic solar cell structures.

### Background to the Invention

The excellent electrical, optical and mechanical properties of zinc oxide, coupled with the relatively low cost, high throughput, techniques available to deposit uniform transparent films, enable the material to be employed in a number of technologies such as OLEDS, gas sensors, heat mirrors and piezoelectric devices. One particular application in which zinc oxide is particularly suited is as a front contact in photovoltaic solar cell structures.

It has been estimated that an output reduction of up to 50% can be observed when spot dirt or contaminants occupies as little as 3% of a photovoltaic module area, as referenced in a paper published by S. Kobayashi, Y. Aoyama, M. Kano, T. Yachi. IEEE Conference Proceeding, 29th International Telecommunications Energy Conference, INTELEC 2007, 2007, pp 429. There is therefore a need in the industry to provide a self-cleaning solution for solar panels as typically solar panels are placed on roof tops and inaccessible areas.

Examples of existing self-cleaning solar panel systems are well known in the industry. Heliotex^{™}, http://www.solarpanelcleaningsystems.com/ provides 'The Heliotex™ Automatic Solar Panel Cleaning System' that places spray nozzles at each panel. Specially formulated soap is mixed into the line for the wash cycle to clean the panels. The Heliotex™ system is a mechanical solution to the problem.

BP Solar Panels, http://www.oronairsales.co.uk/bp-photovoltaic -solar-panel-125-watt-bp-125-3-series-12v-895-p.asp, discloses photovoltaic solar panels with a tempered glass substrate that is self-cleaning to rainfall. The self-cleaning film is coated on a separate glass sheet that does not perform any other function.

PCT patent publication number WO200709096 discloses a solar panel comprising a flexible photovoltaic film and, on one side of the photovoltaic film, an adhesive film for fastening the photovoltaic film to the roof of a vehicle. The panel is **characterized in that** it includes on the other side of the photovoltaic film, a self-cleaning film transparent to ultraviolet rays.

US patent publication number US2007017567 discloses self-cleaning protective coatings for use with photovoltaic cells. This US patent publication also discloses systems and materials to improve photovoltaic cell efficiency by implementing a self-cleaning function on photovoltaic cells and on albedo surfaces associated with photovoltaic cell assemblies are provided. Materials for protecting albedo surfaces that surround photovoltaic cell assemblies, thereby maximizing energy input into the photovoltaic cell assemblies, are provided. Materials for self-cleaning photovoltaic cell panels, thereby maintaining their efficiency, are provided. Portable albedo collecting devices associated with photovoltaic cell assemblies are provided.

A number of processes have been proposed to produce zinc oxide layers efficiently. A journal publication entitled: 'Fabrication and Wettability of ZnO Nanorod Array' by M. Sun, Y Du, WC Hao, HZ Xu, YX, Yu, TM Wang. Journal of Materials Science & Technology, Vol 25, Issue: 1, pg 53-57, 2009 discloses zinc oxide (ZnO) nanorod arrays that are prepared in an open system by using a simple aqueous solution method. Surface character of ZnO nanorod arrays can be changed from hydrophobic to hydrophilic, which was proved to be dependent on size of air grooves on the surface.

Another journal publication entitled 'Wetting Characteristics on Micro/Nanostructured Zinc Oxide Coatings' Kuan CY, Hon, MH Chou, JM, Leu, IC, AF Kuan, C. Y., Hon, M. H., Chou, J. M., Leu, I. C. Journal of the Electrochemical Society, Vol 156, Issue 2, pg J32-J36, 2009 discloses a method of making nano-imprinted sol-gel-derived ZnO coatings. The deposited ZnO gel film exhibits hydrophilicity owing to the adsorption of OH groups on the surface. The regular micro/nanopattern fabricated by nanoimprinting will prevent water from completely contacting the solid surface by trapping air bubbles at the water-solid interfaces, and the surface properties are hydrophobic. Furthermore, the micro/nanopatterned surfaces served as substrates for ZnO nanostructure deposition, and the patterned composite structures are obtained. The surface properties of the composite structure can be adjusted to more hydrophobic or hydrophilic, and the mechanism is demonstrated.

A journal publication entitled 'Photoinduced hydrophilic property of zinc oxide thin films prepared by sol-gel dip coating method' Numpud, P, Charinpanitkul, T, Tanthapanichakoon, W. Journal of the Ceramic Society of Japan, Vol 116, Issue 1351, pg 414-417, 2008 discloses how ZnO thin films can be fabricated on soda lime glass substrates by sol-gel dip coating method.

A paper published entitled 'Photoinduced hydrophilicity of heteroepitaxially grown ZnO thin films' Miyauchi, M, Shimai, A. Journal of Physical Chemistry B, Vol 109, Issue 27, pg 13307-13311, 2005 discloses single crystalline ZnO thin films were heteroepitaxially grown on sapphire substrates by rf-magnetron sputtering.

It has been shown that zinc oxide thin films can be grown using aerosol assisted CVD. For example, a paper entitled 'Zinc Oxide Thin Films Grown by Aerosol Assisted CVD' Waugh, MR, Hyett, G, Parkin, IP. Chemical Vapour Deposition, Vol 14, Issue 11-12, pg 366-372, 2008 discloses a process where zinc oxide (ZnO) thin films are deposited at 400-650 degrees C onto glass substrates by aerosol assisted (AA)CVD of a zinc acetate [Zn(C2H3O2)(2)] solution in methanol. The thin films show high transparency over the visible and infrared regions (80-95%) and a 001 (c-axis) preferred orientation. The surface morphology and crystallographic orientation are dependent on the substrate temperature. The photocatalytic activity of the films is determined using the destruction of stearic acid (SA) by UV irradiation, and the UV induced hydrophobic to hydrophilic conversion, measured using contact angle goniometery.

A conference proceeding entitled 'Chromium doped Zinc oxide thin films deposited by chemical spray used in photocatalysis and gas sensing'Maldonado, A., Mallen-Hernandez, S. A., Vega-Perez, J., Olvera, M. de la L., Tirado-Guerra, S. Revista Mexicana de Fisica, Vol 55,Issue 1, pg 90-94, 2009, 17th International Materials Research Congress, discloses chromium-doped zinc oxide, ZnO:Cr, thin films deposited onto glass substrates by the chemical spray technique. The effect of both the chromium concentration in the solution and the film thickness on the photocatalytic and gas sensing properties of the films was investigated. A decrease in the photocatalytic activity was observed with an increase in the Cr concentration in solution.

There is therefore a need to provide a multi-functional self-cleaning coating material, which is also conducting, that can be employed as a front contact in a solar cell for generating electricity i.e. as the transparent conducting oxide (TCO), that overcomes the above mentioned problems.

### Summary of the Invention

According to the invention there is provided, as set out in the appended claims, a self-cleaning material suitable for use as a front contact in a photovoltaic solar cell structure comprising zinc oxide and indium.

The advantage of the invention is to provide a multifunctional thin film, properties of which include (1) transparency, (2) high levels of conductance, (3) durability (4) UV induced photocatalysis and (5) a hydrophilic surface that can be employed as the front contact on solar cells to minimise the build up of contaminants whilst generating electricity efficiently. By selection of a suitable amount of indium doping in the zinc oxide the invention offers a number of advantages over those associated with existing self-cleaning materials in that it results in the production of self-cleaning properties in a highly conducting film.

In one embodiment, aerosol assisted CVD is applied to a mixture of zinc acetate dissolved in a solvent, typically but not exclusively methanol and indium chloride to produce said self-cleaning material. The inventors found that the addition of indium, at certain levels in the precursor suspension, increased the self-cleaning properties when compared to un-doped films. It will be appreciated that it may be possible to use indium acetate or indium acetyleacetonate instead of indium chloride.

In one embodiment the self-cleaning material comprises transparent properties.

In one embodiment the indium doping increases the conductive properties of said self-cleaning material.

In one embodiment, the self-cleaning material been exposed to ultra violet radiation which is absorbed across the electronic band gap of the material creating electron-hole pairs and these species react at the surface of the material via the process of photocatalytic oxidation to degrade any organic contaminants (including biologically active species such as bacteria and viruses) on said surface.

In one embodiment the material comprises hydrophilic properties. Films produced according to the invention have a hydrophilic surface. Organic contaminants on the surface, cause the film to appear hydrophobic. UV induced oxidation of organic contaminants, as previously discussed, reveals the hydrophilic nature of the surface of the In-doped ZnO film.

In one embodiment the self-cleaning material is in the form of a thin-film sheet.

In one embodiment the material comprises less than 4% of indium. From the initial results 2 % indium would appear to be the optimum amount in terms of the desired conductivity, photoactivity and hydrophilicity. The UV light enables the In-doped ZnO to oxidise organic contaminants on the surface to reveal the naturally hydrophilic surfaces underneath. All the films have been shown to be photoactive in degrading organic contaminants (stearic acid test).

In another embodiment there is provided a self-cleaning antibacterial surface comprising a layer a self-cleaning material comprising zinc oxide and indium. The coating may be also used as a robust self-cleaning and potentially anti-bacterial and anti-viral surface, when irradiated with UV light.

In another embodiment of the invention there is provided a process for producing a self-cleaning material comprising the steps of:
dissolving zinc acetate or some other zinc containing molecule in methanol, or some other convenient solvent, and adding a dopant, for example indium chloride, to provide a suspension ;
depositing zinc oxide doped with indium on a substrate by aerosol assisted chemical vapour deposition (AACVD) from said suspension to produce a layer of said self-cleaning material on said substrate.

The advantage of the process of the present invention is that the process allows for multifunctional conducting, transparent, self-cleaning films to be deposited over large areas using a simple room temperature delivery system containing all of the reactants for film growth and doping, to achieve desirable levels of conductivity, in a 'one-pot' process.

In one embodiment the step of depositing further comprises the step of holding the suspension, in a container, over a metal diaphragm vibrating at ultrasonic frequencies to generate an aerosol of the suspension.

In one embodiment the aerosol of suspension is transported toward the substrate to be coated with self-cleaning material by an inert carrier gas, such as nitrogen.

In one embodiment the substrate is heated allowing chemical and physical reactions associated with chemical vapour deposition to occur when the reactants contained in the aerosol of suspension are deposited on the substrate.

In one embodiment the invention comprises use of zinc oxide, doped with indium, as a transparent, hydrophilic self-cleaning material.

In one embodiment the invention comprises use of zinc oxide, doped with other materials including Ga and Al, as a transparent, hydrophilic self-cleaning material.

In one embodiment the invention comprises use of zinc oxide, doped with In, Ga or Al, as an antibacterial surface.

### Brief Description of the Drawings

The invention will be more clearly understood from the following description of an embodiment thereof, given by way of example only, with reference to the accompanying drawings, in which:
Figure 1 illustrates a side view of the self-cleaning layer/film showing the 3 at. % In-ZnO film, according to one aspect of the invention;
Figure 2 illustrates X-ray diffraction (XRD) data for indium-doped films deposited at 425°C (a) Plain zinc oxide film, 0 at.% indium (b) 2 at. % indium and (c) 3 at. % indium suspended in the precursor;
Figure 3 illustrates tapping mode atomic force microscope (AFM) images of In-doped ZnO films deposited from precursor suspensions containing (a) 3 at. % indium (b) 2 at. % indium and (c) 0 at. % indium in the precursor suspension;
Figure 4 illustrates the reciprocal contact angle data recorded as a function of UV irradiation time (352 nm, 3mW/cm²) for In-doped ZnO films deposited from precursor suspensions containing (a) 0 at. % indium (b) 2 at. % indium and (c) 3 at. % indium dissolved in the precursor suspension;
Figure 5 illustrates the influence of the droplet dispense/measurement/nitrogen drying cycle on the contact angle of the In-doped ZnO film deposited from the 2 at. % indium precursor suspension;
Figure 6 illustrates the stearic acid test data showing the integrated area under CH stretching (asymmetric and symmetric) peaks between 2800 and 3000 cm⁻¹ plotted as a function of UV (352 nm, 3mW/cm²) irradiation time for (a) 0 at. % (b) 2 at. % and (c) 3 at. % indium in the precursor suspension;
Figure 7 illustrates a sample apparatus to produce the self-cleaning material according to another aspect of the invention; and
Figure 8 illustrates an example flow chart illustrating the steps of how to make the self-cleaning materials using the apparatus of Figure 7.

### Detailed Description of the Drawings

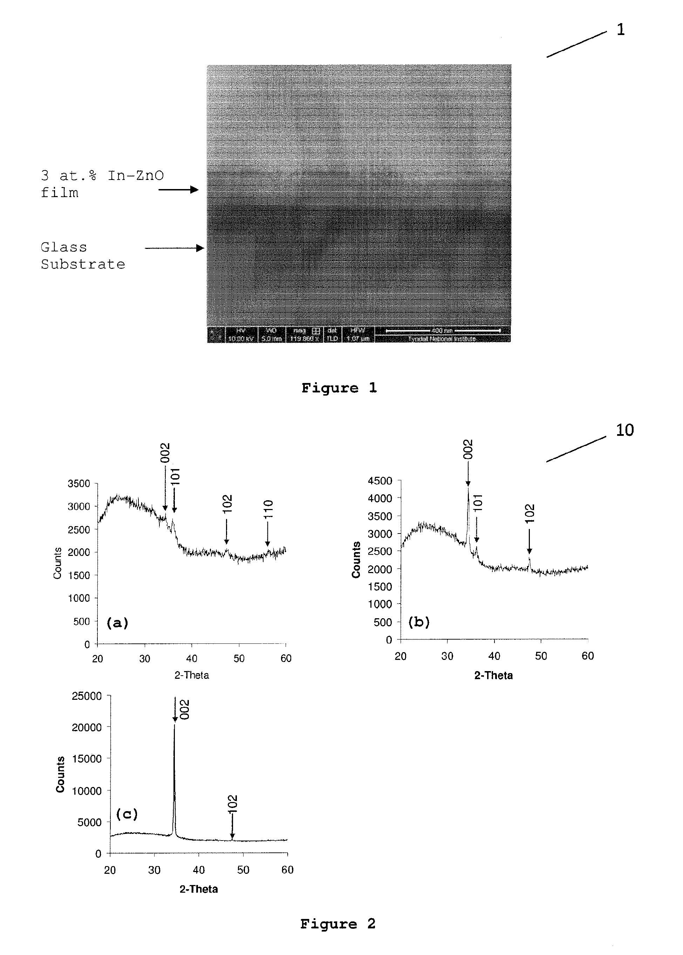

Referring now to the drawings, Figure 1 illustrates a side view of the cleaning material according to the present invention, indicated by the reference numeral 1. The cleaning material preferably comprises zinc oxide and doped with indium to provide a hydrophilic surface, with UV induced photocatalytic properties and excellent transparency properties. The inventors of the present application realised that doping the zinc oxide with a relatively small amount of indium altered the crystallinity to provide a self-cleaning transparent hydrophilic material. One important application of the invention is to deposit a layer of self-cleaning material on the front end of a solar panel. The properties of the self-cleaning material and how to make the material are discussed in more detail below.

Figure 2 shows the x-ray diffraction data for films deposited, at 425°C, with 0, 2 and 3 at. % indium in the precursor suspension, indicated by the reference numeral 20. The films can also be deposited at room temperature. From Figure 2 it can be seen that as the level of indium doping in the precursor suspension is increased, the orientation of the film changes from polycrystalline 002, 101, 102, 110 (0 at. %) to a preferred orientation of 002 (3 at. %). It will be appreciated that the indium changes the way the ZnO crystallizes, with the sharper peaks in the XRD being indicative of more crystalline material.

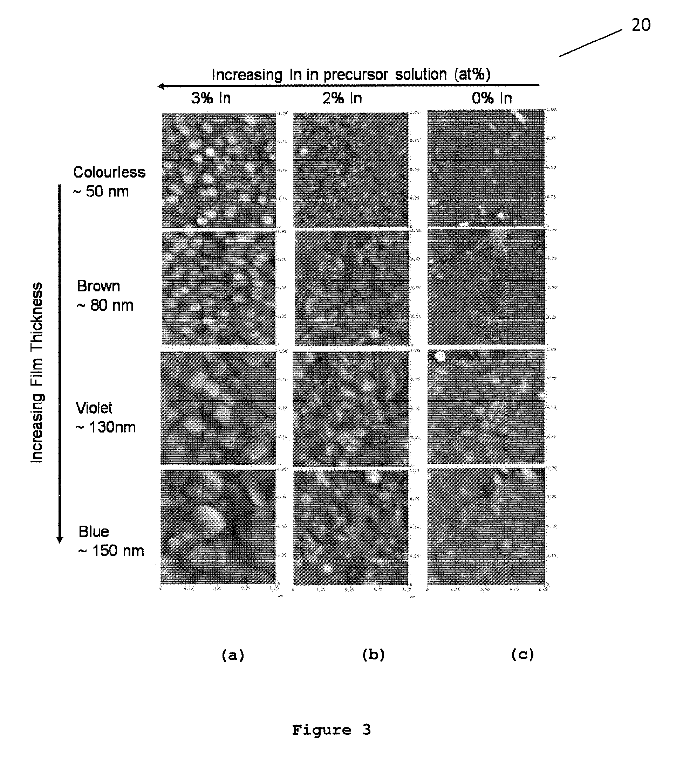

Figure 3, indicated by the reference numeral 20, illustrates the tapping mode atomic force microscope images of In-doped ZnO films deposited, at 425°C, from precursor suspensions containing (a) 3 at. % (b) 2 at. % and (c) 0 at. % indium suspended in the solution containing the precursor. The influence of indium loading in this precursor suspension on the morphology over varying film thickness is shown. Referring to figure 3 in more detail it can be seen that, for a given film thickness, increasing the level of indium in the precursor suspension has a significant influence on the morphology of the films. For a given film thickness a higher at. % of indium increases the grain size and shape e.g. for a film thickness of approx 150 nm it can be seen that the grain size has increased from ∼30 nm (0 at. %) to greater than ∼200 nm (3 at. %) (with a grain of ∼300 nm clearly visible in the 3 at.% film. The 0 at. % film contains closely packed grains with a circular shape, and the 3 at. % the films possess randomly orientated flat plate like grains. For the same film thickness, the RMS of the film was found to be 2.6, 9.5 and 17.0 nm across the image for the 0, 2 and 3 at.% indium films respectively.

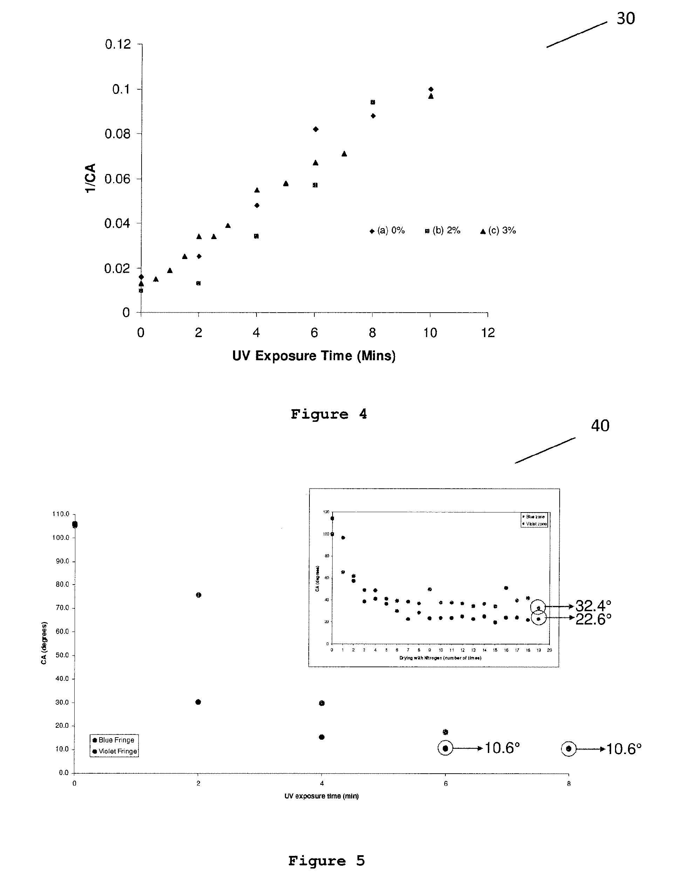

Figure 4, indicated by the reference numeral 30, demonstrates the reciprocal contact angle data recorded as a function of UV irradiation time (352 nm, 3mW/cm²) for In-doped ZnO films deposited from precursor suspensions containing (a) 0 at. % (b) 2 at. % and (c) 3 at. % indium (Fringes analysed were approx. 150 nm thick). The films had been left in the dark in a container open to the atmosphere for approximately one week prior to measurement. Table 1 shows the rates of UV induced hydrophobic to hydrophilic conversion taken from the gradients of the reciprocal contact angle data (figure 4) for (a) 0 at. % indium (b) 2 at. % indium and (c) 3 at. % indium suspended in the precursor solution. Table 1 shows the gradient of each trend allowing a relative hydrophobic to hydrophilic conversion rate to be determined (degrees⁻¹ min⁻¹). Examining table 1 in more detail, it can be seen that the addition of 2 at. % indium improves the UV induced hydrophobic/hydrophilic conversion rate slightly, but as the level of indium in the precursor suspension is increased to 3 at. % the conversion rate decreases to a point below that of the un-doped film.

**Table 1**

| at. % In in Precursor | Rate degrees-1 min-1 |
|---|---|
| (a) 0 | 0.0092 |
| (b) 2 | 0.0107 |
| (c) 3 | 0.0078 |

Figure 5, indicated by the reference numeral 40, demonstrates the influence of the droplet dispense/measurement/nitrogen drying cycle on the contact angle of the In-doped ZnO film deposited from the 2 at. % In precursor suspension on 150 nm (blue) and 130nm (violet) fringes. (The inset shows the contact angle data for the same film). Again the films had been left in the dark in a container open to the atmosphere for approximately one week prior to measurement. The results reveal that the films surface is naturally hydrophilic and the UV hydrophobic to hydrophilic conversion is due to organic contamination oxidation. The final contact angle of between 22-32° after 19 droplet/drying cycles compared to 10° after 6-8 minutes UV exposure (4-5 droplet/drying cycles) supports this. As the hydrophobic/hydrophilic conversion has been shown to be influenced by the measurement technique, it is not possible to definitively conclude that the relative UV induced conversion rates, discussed previously and shown in figure 3 and table 1, accurately represent the true rate. However, it can be speculated that the films deposited exhibit a hydrophilic property in their clean, un-contaminated, state, and this property can be maintained through the oxidation of organic contaminants, proven to cause photocatalytic films to display hydrophobic properties.

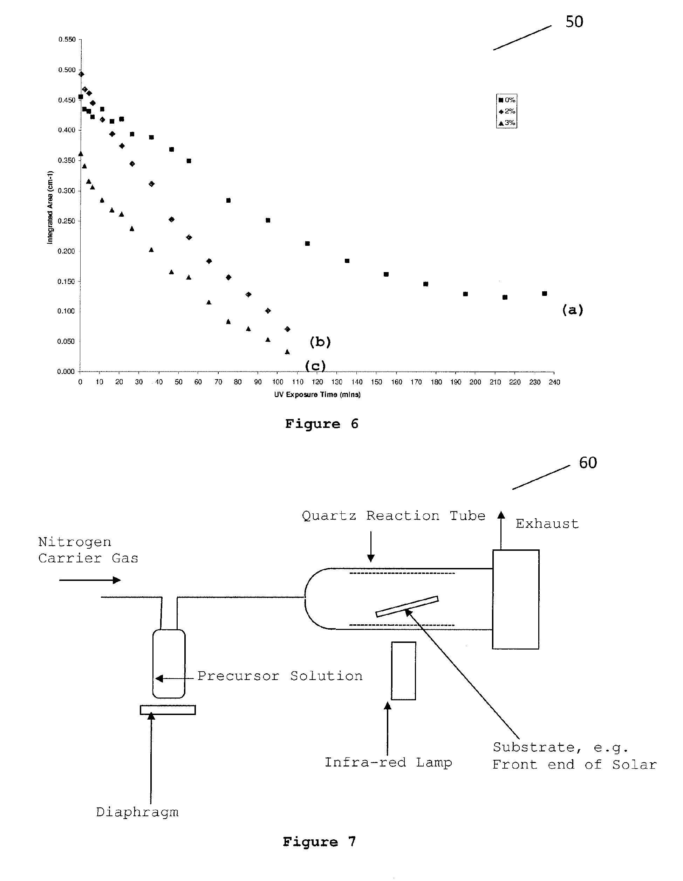

Figure 6, indicated by the reference numeral 50, shows stearic acid degradation data recorded as a function of UV irradiation time (352 nm, 3mW/cm²) for In-ZnO films deposited from precursor suspensions containing (a) 0 at. % (b) 2 at. % and (c) 3 at. % indium dissolved in the precursor suspension. The initial trends suggest that the addition of 2 at. % indium improves the oxidation of organic contaminants over the 0 at.% film, with a reduction of this rate at 3 at. % (compared to the 2 at. %).

Table 2 shows the rate of stearic acid degradation taken from the gradients of the integrated area (figure 5) for (a) 0 at. % indium (b) 2 at. % indium and (c) 3 at. % indium suspended in the precursor solution.

**Table 2**

| at. % In in Precursor | Rate (cm-1min-1) |
|---|---|
| (a) 0 | 0.0016 |
| (b) 2 | 0.0040 |
| (c) 3 | 0.0030 |

Secondary Ion Mass spectroscopy (SIMS) has been carried out on the films (Loughborough Surface Analysis Ltd). The aerosol assisted CVD technique of the indium chloride doped suspension has been shown to incorporate indium into the zinc oxide films in a 'one pot' process.

Table 3, 4 and 5 shows basic resistance measurements from the films. These initial measurements suggest that in general the addition of indium increases the conductivity of the films, with the 2 at. % film giving the lowest resistance.

Table 3 shows the resistance measurements conducted on a sample deposited from a precursor suspension containing 0 at.% indium . The measurements were carried out using an Ohmmeter over a distance of 5 mm in a grid pattern.

Table 4 shows the resistance measurements conducted on a sample deposited from a precursor suspension containing 2 at.% In. The measurements were carried out using an Ohmmeter over a distance of 5 mm in a grid pattern.

Table 5 shows the resistance measurements conducted on a sample deposited from a precursor suspension containing 3 at.% In. The measurements were carried out using an Ohmmeter over a distance of 5 mm in a grid pattern.

**Table 3**

| Grid Position | Colour fringe | Resistance |
|---|---|---|
| 14C/D | Golden yellow | 1.2MΩ, |
| 13C/D | Whistish Green | No reading |
| 12C/D | Blue | No reading |
| 11C/D | Blue | No reading |
| 10C/D | Blue/Violet | No reading |
| 9C/D | Violet | 25.5MΩ, |
| 8C/D | Violet | 0.6MΩ, |
| 7C/D | Violet | 80kΩ |
| 6C/D | Violet | 36KΩ |
| 5C/D | Violet | 110KΩ |
| 4C/D | Brown/Violet | 9.4MΩ, |

**Table 4**

| Grid Position | Colour fringe | Resistance |
|---|---|---|
| 14C/D | Whitish Green | 5.4kΩ |
| 13C/D | Blue | 8.03kΩ |
| 12C/D | Blue | 7.7kΩ |
| 11C/D | Blue/Violet | 7.55kΩ |
| 10C/D | Violet | 7.05kΩ |
| 9C/D | Violet | 6.5kΩ |
| 8C/D | Violet | 5.1kΩ |
| 7C/D | Violet | 6.1kΩ |
| 6C/D | Brown/Violet | 5.8kΩ |
| 5C/D | Colourless/Brown | 19.1MΩ |
| 4C/D | No Film | N.A |

**Table 5**

| Grid Position | Colour fringe | Resistance |
|---|---|---|
| 14C/D | Blue | 6.4kSz |
| 13C/D | Blue/Violet | 13.2kSZ |
| 12C/D | Violet | 24.01kΩ |
| 11C/D | Violet | 42.4kΩ |
| 10C/D | Violet/Brown | 52.4kΩ |
| 9C/D | Violet/Brown | 34.8kΩ |
| 8C/D | Violet/Brown | 23.6kΩ |
| 7C/D | Brown | 13.1kΩ |
| 6C/D | Brown | 18.9kΩ |
| 5C/D | Brown/Colourless | 188.5kΩ |
| 4C/D | Colourless | 6.9MΩ |

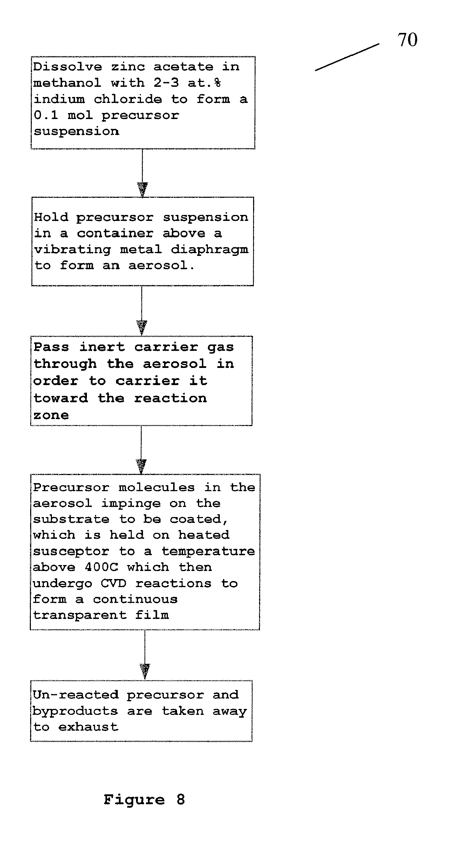

Referring now to Figures 7 a system for making the self-cleaning material of the invention is shown, indicated by the reference numeral 60. An example process for making the self-cleaning material is shown in the flow chart shown in Figure 8, indicated by the reference numeral 70. One preferred way of making the self-cleaning material is provided by depositing thin films of zinc oxide doped with indium are deposited by aerosol assisted chemical vapour deposition (AACVD). This involves zinc acetate being dissolved in methanol, or some other zinc containing molecule in methanol, or some other convenient solvent and the dopant indium chloride being added.

Holding the suspension, in a container, over a small metal diaphragm vibrating at ultrasonic frequencies, generates an aerosol of the suspension. The aerosol is transported toward the substrate to be coated by an inert carrier gas, such as nitrogen. The substrate to be coated is heated allowing the reactions associated with chemical vapour deposition to occur when the reactants contained in the aerosol impinge on the surface.

The doped zinc oxide films deposited have conducting, transparent, hydrophilic, self-cleaning properties that make them ideal as transparent front contacts in solar cells. The self-cleaning properties will help to maintain the efficiency of the solar cell over time, by reducing the build up of contaminants on the surface.

It will be appreciated in the context of the present invention that other dopants can be used instead of indium, for example aluminium or gallium can be used or other suitable elements. In addition instead of zinc-oxide cadmium-oxide can be used.

It will be further appreciated that the self-cleaning material described with reference to the description and drawings can be used in applications relating to microfluidic devices and switches, zinc-oxide display screens, thin-film-transistor (TFT) applications or any device that requires a transparent/conducting self-cleaning surface.

The invention is not limited to the embodiments hereinbefore described but may be varied in both construction and detail.

## Claims

1. A self-cleaning material, suitable for use as a front contact in a photovoltaic solar cell structure, comprising zinc oxide and indium.

2. The self-cleaning material of claim 1 wherein zinc oxide crystallises with said indium to produce said self-cleaning surface.

3. The self-cleaning material of any preceding claim wherein said self-cleaning material comprises transparent properties.

4. The self-cleaning material of any preceding claim wherein said indium doping increases the conductive properties of said self-cleaning material.

5. The self-cleaning material of any preceding claim wherein said material comprises hydrophilic properties.

6. The self-cleaning material as claimed in claim 5 wherein, on said material being exposed to ultra violet radiation said film degrades any organic contaminants present on said surface.

7. The self-cleaning material of any preceding claim wherein said self-cleaning material is in the form of a thin-film sheet and applied to a photovoltaic solar cell structure to provide a transparent self-cleaning surface.

8. The self-cleaning material of any preceding claim wherein said material comprises less than 4 atomic% of indium.

9. An antibacterial surface comprising the self-cleaning material of any of claims 1 to 8.

10. A process for producing a self-cleaning material comprising the steps of:
dissolving zinc acetate or some other zinc containing molecule in methanol, or some other convenient solvent, and adding a dopant, for example indium chloride, to provide a suspension ;
depositing zinc oxide doped with indium on a substrate by aerosol assisted chemical vapour deposition (AACVD) from said suspension to produce a layer of said self-cleaning material on said substrate.

11. The process as claimed in claim 10 wherein the step of depositing further comprises the step of holding the suspension, in a container, over a metal plate vibrating at ultrasonic frequencies to generate an aerosol of the suspension.

12. The process as claimed in claims 10 or 11 wherein said aerosol of suspension is transported toward the substrate to be coated with self-cleaning material by an inert carrier gas, such as nitrogen.

13. The process as claimed in claims 10 to 12 wherein the substrate is heated allowing reactions associated with chemical vapour deposition to occur when the reactants contained in the aerosol of suspension are deposited on the substrate.

14. A front contact in a photovoltaic solar cell structure comprising a layer of self-cleaning zinc oxide material doped with indium.

15. Use of zinc oxide, doped with indium, as a transparent, hydrophilic self-cleaning material.
